# EUROPEAN PATENT APPLICATION

(11) **EP 4 576 149 A2**
(43) Date of publication of application: **25.06.2025**
(21) Application number: 25174125.2
(22) Date of filing: 02.05.2025
(51) Int. Cl.: H01H 35/32, H01J 37/04

(54) **ELECTRICAL CONNECTION SYSTEM**

(71) Applicant: ASML Netherlands B.V., 5500 AH Veldhoven (NL)
(72) Inventor: VAN DER TOORN, Jan-Gerard, Cornelis, 5500 AH Veldhoven (NL)
(74) Representative: ASML Netherlands B.V.

(57) **Abstract**

An electrical connection system 300 comprising:
a first body 310;
a first electrical contact member 311 attached to the first body;
a second body 320 movable relative to the first body;
a second electrical contact member 321 attached to the second body; and
a passive pneumatic actuator 322 configured to change length in a first direction in response to changes in the fluid pressure surrounding the pneumatic actuator;
wherein, in a disconnected state, the pneumatic actuator has a first length whereby the first and second electrical contact members 311, 321 are not in electrical contact;
wherein, in a connected state, the pneumatic actuator has a second length whereby the first and second electrical contact members 311, 321 are in electrical contact;
wherein the system further comprises a first compliant member 315 through which the first electrical contact member 311 is attached to the first body 310, and the first compliant member 315 is configured to accommodate relative movements between the first and second bodies 310, 320 in a second direction different from the first direction.

## Description

### FIELD

This disclosure relates to electrical connection systems capable of passive transition between connected and disconnected states.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect)
inspection. The interaction products may contain charged particles which may be referred to as signal particles (e.g. signal electrons), such as secondary electrons and backscattered electrons, and may contain other interaction products, such as X-ray radiation and even light.

The primary beams are vulnerable to interference from nearby voltage sources like interferometers and sensors. A voltage shield may be provided to shield the primary beams from these interreferences. The voltage shield may be connected to an electron-optical device within the charged particle system, and may span the full movement range of the substrate. To facilitate extraction of the electron-optical device, the voltage shield may be divided into an inner part attached to the electron-optical device and an outer part connected to the system casing. To avoid transmitting mechanical vibrations, a gap may be left between the inner and outer parts of the voltage shield. However, in order to avoid distorting the electrical fields around the primary beams, it may be desirable to maintain the inner and outer parts of the voltage shield at the same electric potential. A straightforward implementation may be to connect the inner and outer parts of the voltage shield using a flexible electric cable. However, the cable may be difficult to access before the electron-optical device has been extracted, and, before disconnecting the cable, it may be difficult to extract the electron-optical device.

### SUMMARY

An object of the invention is to facilitate separation of electrically connected components, e.g. during maintenance.

Another object of the invention is to facilitate establishing an electrical connection between components, e.g. after maintenance.

Another object of the invention is to automate the electrical connection and/or disconnection of components. A further object is to improve the reliability of this automation.

In accordance with an embodiment, there is disclosed an electrical connection system comprising:
a first body;
a first electrical contact member attached to the first body;
a second body movable relative to the first body;
a second electrical contact member attached to the second body; and
a passive pneumatic actuator configured to change length in a first direction in response to changes in the fluid pressure surrounding the pneumatic actuator;
wherein, in a disconnected state, the pneumatic actuator is in a first length whereby the first and second electrical contact members are not in electrical contact;
wherein, in a connected state, the pneumatic actuator is in a second length whereby the first and second electrical contact members are in electrical contact;
wherein the system further comprises a first compliant member through which the first electrical contact member is attached to the first body, and the first compliant member is configured to accommodate relative movements between the first and second bodies.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts an alternative multi-beam charged particle-optical device, for example of the assessment apparatus of Figure 1;
- Figure 7 schematically depicts a single beam charged particle-optical device, for example of the assessment apparatus of Figure 1;
- Figure 8 schematically depicts an alternative multi-beam charged particle-optical device, for example of the assessment apparatus of Figure 1;
- Figure 9 schematically depicts part of the multi-beam charged particle-optical device of Figure 8;
- Figure 10 schematically depicts a detector array in plan view;
- Figure 11 schematically depicts a detector element in cross-section;
- Figure 12 schematically depicts an electrical connection system;
- Figure 13A schematically depicts the electrical connection system in a disconnected state;
- Figure 13B schematically depicts the electrical connection system in a connected state;
- Figure 14A schematically depicts the electrical connection system accommodating movements in a first direction;
- Figure 14B schematically depicts the electrical connection system accommodating movements in another direction;
- Figure 14C schematically depicts the electrical connection system accommodating movements in another direction; and
- Figure 15 schematically depicts another electrical connection system.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

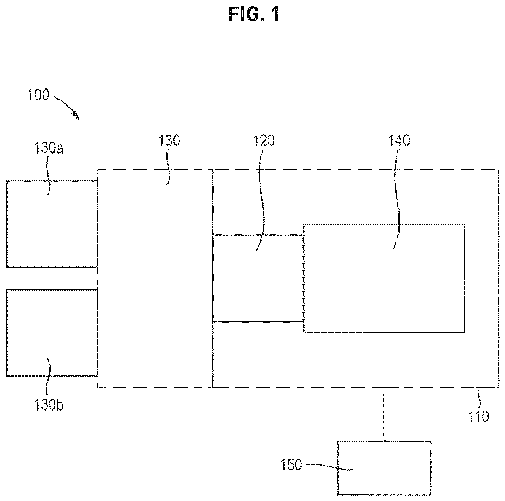

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

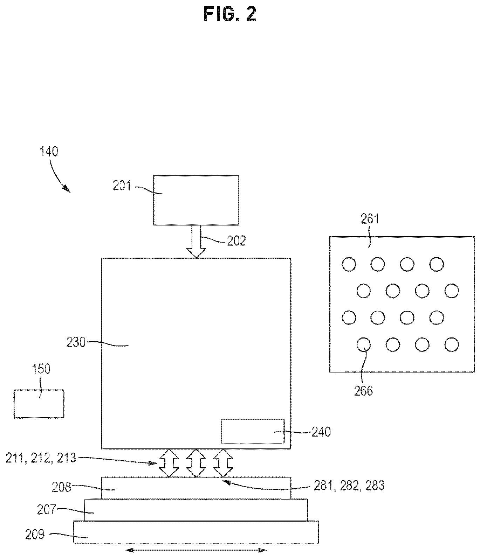

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

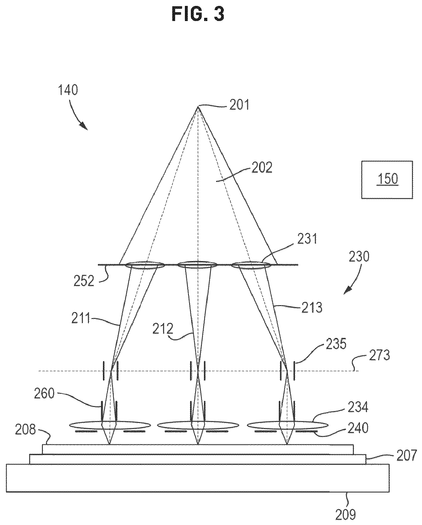

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

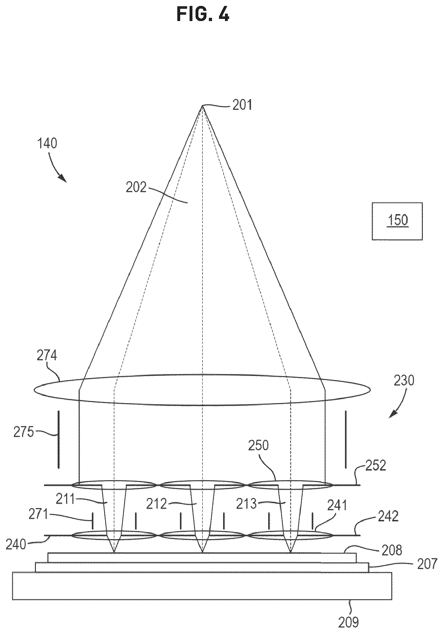

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

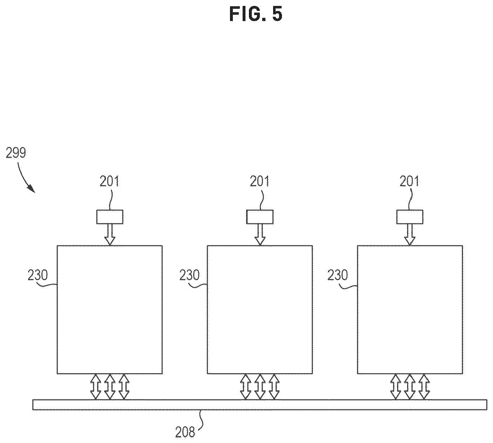

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

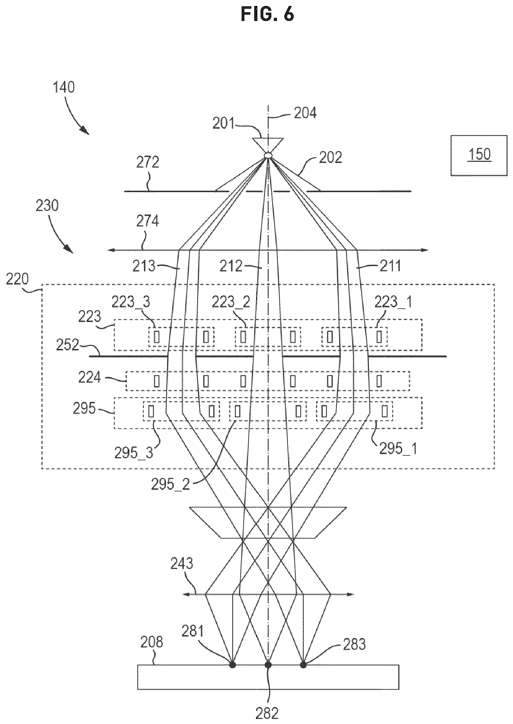

Figure 6 schematically depicts an electron-optical apparatus 140 of an assessment apparatus, e.g. the assessment apparatus 100 of Figure 1. The electron-optical apparatus 140 comprises an electron-optical device 230. The field of view of the electron-optical device 230 may be, for example, of the order of 100s of microns across the primary beams 211, 212, 213 at the sample 208. The electron-optical apparatus 140 of Figure 6 may be the electron-optical apparatus 140 of Figure 2 in which the electron-optical device 230 comprises a Coulomb aperture array 272, a macro condenser lens 274, a source converter (or micro-optical array) 220 and an objective lens 243. The electron-optical apparatus 140 defines an electron-optical axis 204. The Coulomb aperture array 272 may be referred to as a beam former array.

The source 201 generates a source beam 202. The Coulomb aperture array 272 defines a plurality of primary beams 211, 212, 213 from the source beam 202. The Coulomb aperture array 272, in operation, is configured to block off peripheral electrons to reduce electron-electron interactions (also referred to as Coulomb interactions) that may generate aberrations.

The macro condenser lens 274 is configured to at least partly collimate the primary beams 211, 212, 213. In an embodiment the macro condenser lens 274 is magnetic. The macro condenser lens 274 may be a non-rotational condenser lens. In an embodiment the macro condenser lens 274 is configured to operate on a plurality of, optionally all of, the primary beams 211, 212, 213.

The source converter 220 is configured to convert the primary beams 211, 212, 213 transmitted by the Coulomb aperture array 272 into the beams that are directed towards the sample 208. In an embodiment the source converter 220 is a module. Alternatively, the source converter 220 may comprise a plurality of separate electron-optical elements.

In an embodiment the source converter 220 comprises a pre-bending deflector array 223 with pre-bending deflectors 223_1, 223_2, 223_3 configured to deflect respective primary beams 211, 212, 213 toward a beam limiting aperture array 252.

In an embodiment the source converter 220 comprises a beam limiting aperture array 252 with an aperture pattern (i.e. apertures arranged in a formation) configured to define the outer dimensions of the primary beams 211, 212, 213 directed towards the sample 208. The beam limiting aperture array 252 may be a plate 261. In an embodiment, the beam limiting aperture array 252 defines a plurality of beams from each of the primary beams 211, 212, 213 directed to the beam limiting aperture array 252. In an alternative embodiment, the beam limiting aperture array 252 maintains the number of the primary beams 211, 212, 213 incident on the beam limiting aperture array 252.

The source converter 220 may comprise a corrector array such as an aberration reduction array 224 configured to reduce aberrations of the primary beams 211, 212, 213. In an embodiment the aberration reduction array 224 comprises a plurality of lenses configured to operate on respective primary beams 211, 212, 213. The aberration reduction array 224 may, for example, comprise a field curvature compensator array (not shown) comprising lenses. The aberration reduction array 224 may comprise an astigmatism compensator array (not shown) comprising stigmators. The stigmators may, for example, be controlled to operate on the primary beams 211, 212, 213 to reduce astigmatism aberrations.

The source converter 220 may comprise a deflector array 295 comprising deflectors 295_1, 295_2, 295_3 for the beam paths of respective primary beams 211, 212, 213. The deflectors 295_1, 295_2, 295_3 are configured to deflect the beam paths of the primary beams 211, 212, 213 towards the front focal plane of the objective lens 243 to ensure that the individual primary beams 211, 212, 213 will impinge on the sample 208 substantially perpendicular.

In an embodiment the objective lens 243 is magnetic. In an embodiment the objective lens 243 is a macroscopic lens configured to manipulate a plurality of, optionally all of, the primary beams 211, 212, 213 simultaneously. The objective lens 243 focuses the primary beams 211, 212, 213 onto the surface of the sample 208. The primary beams 211, 212, 213 form respective probe spots 281, 282, 283 on the surface of the sample 208. The deflectors 295_1, 295_2, 295_3 of the deflector array 295 deflect the individual primary beams 211, 212, 213 to the front focal plane of the objective lens to ensure that the individual primary beams 211, 212, 213, in use, impinge on the substrate 208 substantially perpendicular. In an embodiment the objective lens 243 is a macroscopic lens containing both magnetic and electrostatic lenses. In such an embodiment the macroscopic electrostatic lenses manipulate the plurality of the primary beams 211, 212, 213 simultaneously. In a further embodiment, the objective lens 243 comprises one or more scan deflectors (electrostatic and/or magnetic) to scan the plurality of primary beams 211, 212, 213 over the substrate 208.

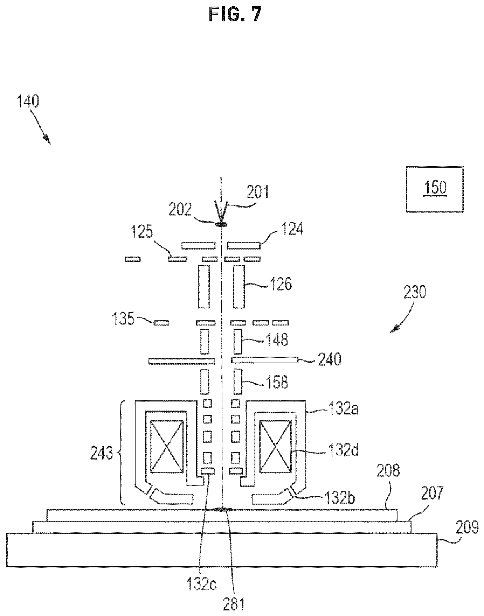

Figure 7 schematically depicts an electron-optical apparatus 140 of an assessment apparatus, e.g. the assessment apparatus 100 of Figure 1. As shown in Figure 7, in an embodiment the electron-optical apparatus 140 comprises an electron-optical device 230 that comprises a beam limit aperture 125 (the image actually shows an array of selectable beam limiting apertures), a condenser lens 126, a column aperture 135 (again indicated as an array of selectable column apertures 135), an objective lens 243 and a detector array 240.

The source 201 is configured to generate a source beam 202. A gun aperture 124 blocks peripheral electrons of the source beam 202. The source beam 202 passes through the beam limit aperture 125, the condenser lens 126 and the column aperture 135. The condenser lens 126 may be magnetic, electrostatic or a combination of magnetic and electrostatic.

In an embodiment the electron-optical device 230 comprises electromagnetic multipole, e.g. quadrupole, electron lenses. For example, the electron-optical device 230 may comprise a first multipole lens 148 and a second multipole lens 158. In an embodiment, the first multipole lens 148 and the second multipole lens 158 are used for controlling the source beam 202. For example, the first multipole lens 148 may be configured to adjust the beam current of the source beam 202. The second multipole lens 158 may be configured to adjust the size of the probe spot 281 and/or the shape of the source beam 202.

The objective lens 243 focuses the source beam 202 onto the sample 208. In an embodiment the objective lens 243 comprises a pole piece 132a, a control electrode 132b, a deflector 132c and an exciting coil 132d. In an embodiment a deflector, such as the deflector 132c or other deflectors in the objective lens 243 are configured to scan the source beam 202 across the surface of the sample 208. The detector array 240 is configured to detect signal electrons from the sample 208.

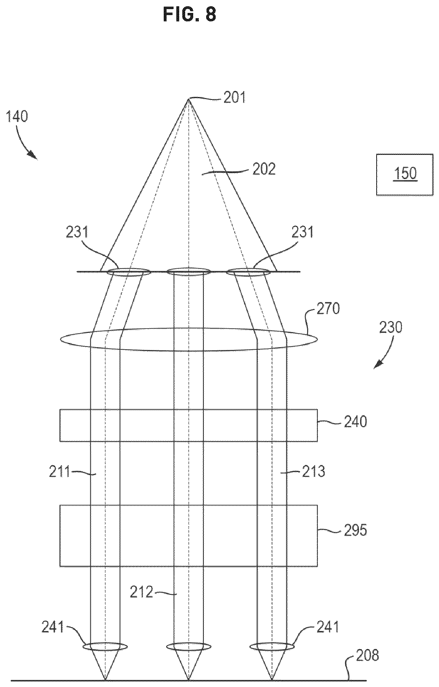

Figure 8 schematically depicts an electron-optical apparatus 140 of an assessment apparatus, e.g. the assessment apparatus 100 of Figure 1. The electron-optical apparatus 140 may be the electron-optical apparatus 140 of Figure 2 in which the electron-optical device 230 comprises a condenser lens array 231, a macro collimator 270, the detector array 240, a deflector array 295 and an objective lens array 241.

Features that are the same as those described above are given the same reference numerals. For conciseness, such features are not described in detail with reference to Figure 8. For example, the source 201, the condenser lens array 231, the objective lens array 241 and the sample 208 may be as described above.

The source is configured to generate a source beam 202. The condenser lens array 231 is configured to define a plurality of primary beams 211, 212, 213 from the source beam 202. The disclosure in EP1602121A1 of a lens array to split a beam into a plurality of beams, with the lens array providing a lens for each beam, is hereby incorporated by reference as a possible implementation of the condenser lens array 231.

In an embodiment the condenser lens array 231 comprises three plates 261 configured as an Einzel lens. An Einzel lens is configured to substantially ensure that the energy of an electron leaving the lens is the same as when the electron arrived at the lens. Such a lens maintains the energy of an electron between arriving and leaving the lens, for example the condenser lenses of the condenser lens array 231. Thus, dispersion only occurs within the condenser lens array 231 itself, thereby limiting chromatic aberrations. When a distance between the three plates of the Einzel lens is small, the chromatic aberrations caused by this condenser lens array 231 is limited, e.g. having a negligible effect.

In an embodiment the electron-optical device 230 comprises a collimator which may be macro collimator 270. The macro collimator 270 bends respective beams by an amount effective to ensure that a beam axis of each of the primary beams 211, 212, 213 derived from the primary 202 beam is incident on the sample 208 substantially normally (i.e. at substantially 90° to the nominal surface of the sample 208). In the current embodiment, the macro collimator 270 acts on all of the primary beams 211, 212, 213. The macro collimator 270 may comprise an electrostatic lens and/or a magnetic lens arrangement comprising a plurality of lens elements (e.g. a plurality of electrostatic and/or magnetic elements, e.g. forming a multipole).

In an embodiment the detector array 240 is configured to detect signal electrons by reference to the energy of the signal electron. For example, scintillators e.g. YAG do not directly detect electrons but generate light which is then detected. The signal electrons emitted from the sample 208 gain energy from the electromagnetic fields between the detector array 240 and the sample 208. In an embodiment, the objective lens array 241 is located between the detector array 240 and the sample 208.

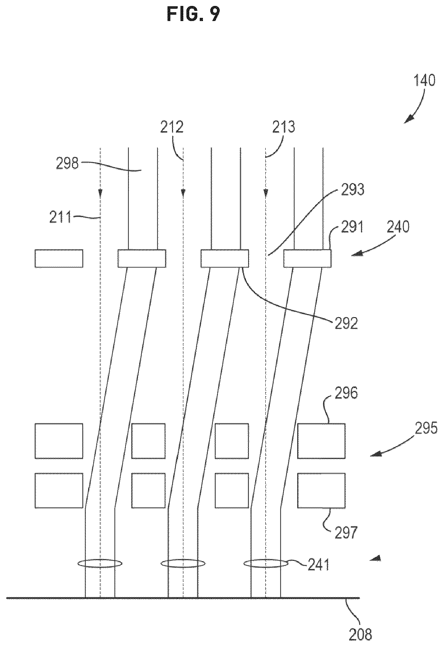

The electron-optical device 230 may comprise a deflector array 295 located between the detector array 240 and the objective lens array 241. The deflector array 295 may be referred to as a beam separator. The deflector array 295 may deflect signal electrons resulting from individual primary beams 211, 212, 213 along a path towards detector elements of a detector array 240 that is away from the paths of the primary beams towards the sample 208. The deflector array 295 may comprise a magnetic deflector array that is configured to provide magnetic fields to disentangle the primary electrons projected toward the sample 208 from the signal (e.g. secondary) electrons emitted from the sample 208. The deflector array 295 may comprise a Wien filter array. The deflector array 295 may comprise an electrostatic deflector array that is arranged to cooperate with the magnetic deflector array to achieve the disentangling of the paths of the primary electrons and signal electrons. Figure 9 is a close-up view of part of the electron-optical device 230 shown in Figure 8. In an embodiment the detector array 240 comprises an electron to photon converter array 291, e.g. a scintillator array. The electron to photon converter array 291 comprises a plurality of fluorescent elements (e.g. comprising YAG) which may be in the form of fluorescent strips 292 extending across the beam grid. Each fluorescent strip 292 is located in the plane of the electron to photon converter array 291. At least one fluorescent strip 292 is arranged between two adjacent primary beams 211, 212, 213 projected towards the sample 208. In an embodiment, the fluorescent strips 292 extend substantially across the beam grid. Alternatively, the electron to photon converter array 291 may comprise a plate of a fluorescent material with openings 293 for the primary beams 211, 212, 213 or an array of elements of similar size around the beams and that may be spaced apart. The primary beams 211, 212, 213 are projected through the plane of the electron to photon converter array 291, e.g. via the openings 293 such as between the fluorescent strips 292, towards the deflector array 295.

In an embodiment the deflector array 295 comprises a magnetic deflector 296 and an electrostatic deflector 297. The electrostatic deflector 297 is configured to counteract the deflection of the magnetic deflector 296 for the primary beams 211, 212, 213 transmitted towards the sample 208. Accordingly, the primary beams 211, 212, 213 may be shifted to a small extent in the horizontal plane. The beam paths downbeam of the deflector array 295 are substantially parallel to the beam paths upbeam of the deflector array 295.

In an embodiment the objective lens array 241 comprises a plurality of plates for guiding signal electrons emitted from the sample 208 towards the deflector array 295. For the signal electrons, which travel in opposite direction with respect to the projected primary beams 211, 212, 213, the electrostatic deflector 297 does not counteract the deflection of the magnetic deflector 296. Instead, the deflections of the secondary electrons by the electrostatic deflector 297 and the magnetic deflector 296 add up. Accordingly, the signal electrons are deflected to travel at an angle with respect to the optical axis in order to transmit the secondary electrons onto the fluorescent strips 292 of the detector array 240.

At the fluorescent strips 292, photons are created upon incidence of the signal electrons. In an embodiment, the photons are transported from the fluorescent strip 292 to a photo detector (not shown) via a photon transport unit. In an embodiment, the photon transport unit comprises an array of optical fibers 298. Each optical fiber 298 comprises an end which is arranged adjacent or attached to one of the fluorescent strips 292 for coupling photons from the fluorescent strip 292 into the optical fiber 298, and another end which is arranged to project photons from the optical fiber 298 onto the photo detector. In a different arrangement, the optical to electrical converter (or photo diode) is located immediately adjacent the electron to light converter, avoiding the need for optical fibers.

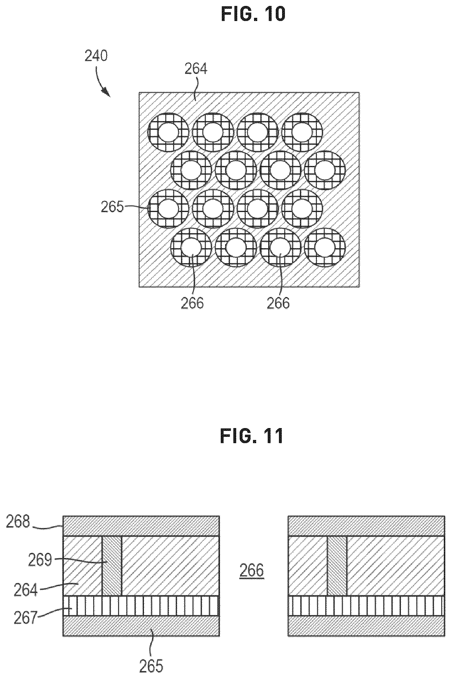

Figure 10 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 10, the beam apertures 266 are in a hexagonal close packed array. The beam apertures 266 can also be differently arranged, e.g. in a rectangular array.

Figure 11 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

In an embodiment the electron-optical apparatus 140 comprises a secondary electron-optical device comprising the detector array 240. In such an embodiment a beam separator typically is arranged to deflect the path of the signal electrons towards the secondary electron-optical device. The secondary electron-optical device subsequently directs the signal electrons towards the detector array 240 and focuses the signal electrons (e.g. secondary electrons) onto the detector array 240.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

The primary beams 211, 212, 213 may be susceptible to interference by nearby voltage sources, particularly high-voltage sources. Example sources of interference include interferometers and various sensors. Often, components of the electron-optical device 230 are maintained at a large negative voltage. As such, external components that are at (absolute) ground potential may also be sources of interference. As such, it may be desirable to shield the primary beams 211, 212, 213 from such interferences. For example, the electron-optical device 230 may comprise a voltage shield (not shown) configured to shield the primary beams 211, 212, 213 from such interferences. The voltage shield may generally be in the form of a plate. The voltage shield may comprise an electrically conductive material, such as a metallic material. The voltage shield may extend laterally from the electron-optical device 230, and may extend far enough to provide voltage shielding over the full extent and the full movable range of the actuatable stage 209. As such, the lateral extent of the voltage shield may be substantially greater than the lateral footprint of the electron-optical device 230.

However, during maintenance, the electron-optical device 230 may need to be extracted from the electron-optical apparatus 140. In order to facilitate removal of the electron-optical device 230, the voltage shield may be divided into an inner part and an outer part (not shown). The inner part may be rigidly attached to the electron-optical device 230. The outer part surrounding the inner part and attached to the casing of the electron-optical apparatus 140, such as via flexible supports. The inner part may have a lateral extent not much larger than the electron-optical device 230, so that it can be extracted together with the electron-optical device 230 relatively easily.

In order to isolate the electron-optical device 230 from mechanical vibrations, it may be desirable to avoid rigid mechanical contact between the inner and outer parts of the voltage shield. For example, a gap may exist between the inner and outer parts of the voltage shield. The gap may surround the inner part. The gap may be shaped so as to maintain continuity of the voltage shield. That is, notwithstanding the existence of the gap, the voltage shield may be shaped to prevent external electric fields from leaking through the gap. For example, the inner and outer parts of the voltage shield may be shaped to maintain a lateral overlap along the gap. There may be enough lateral overlap to accommodate relative movements between the inner and outer parts of the voltage shield resulting from mechanical vibrations. That is, the lateral overlap may be large enough so that the continuity of the voltage shield is maintained even when the relative movements between the inner and outer parts of the voltage shield are at a maximum amplitude.

In order to further prevent distorting the electric fields in the vicinity of the primary beams 211, 212, 213, it may be desirable to maintain the inner and outer parts of the voltage shield at the same electric potential while avoiding creating a rigid mechanical contact between the inner and outer parts of the voltage shield. A straightforward implementation may be to connect the inner and outer parts of the voltage shield using a flexible electric cable (not shown). However, such an electric cable may be difficult to access. Without disconnecting the cable, it may not be possible to extract the electron-optical device 230 from the electron-optical apparatus 140. Therefore, using a flexible electric cable has disadvantages.

It may be desirable to provide an electrical connection system that operates automatically. In particular, it may be desirable for the electrical connection system to operate passively. In this context, the term "passively" may mean that the electrical connection system is able operate without requiring an electrical supply, or without relying on electrical sensors or electro-mechanical actuators. Such an electrical connection system may be useful for implementing the voltage shield. However, it should be understood that the electrical connection system may be used in various other technical applications, including those unrelated to lithography, where a passive and automatic electrical connection is beneficial.

In particular, the electrical connection system may take advantage of changes in a fluid pressure in the environment surrounding the electrical connection system. It should be understood that, as used herein, the term "fluid" encompasses liquids, gasses and/or plasmas. For example, as may be the case for the electron-optical apparatus 140, the voltage shield may be in a relative vacuum (i.e. below atmospheric pressure) environment during normal operation of the electron-optical apparatus 140, and may be in an atmospheric-pressure environment during maintenance of the electron-optical apparatus 140. As such, the electrical connection system may operate in response to this change in pressure. It should be understood that, in technical applications other than in an electron-optical apparatus 140, the pressure change may be between atmospheric pressure and a positive pressure greater than atmospheric pressure. In such technical applications, the electrical connection system may accordingly operate in response to changes between atmospheric and positive pressures. More generally, the electrical connection system may operate in response to pressure changes, irrespective of whether the pressures are positive, negative, or close to atmospheric.

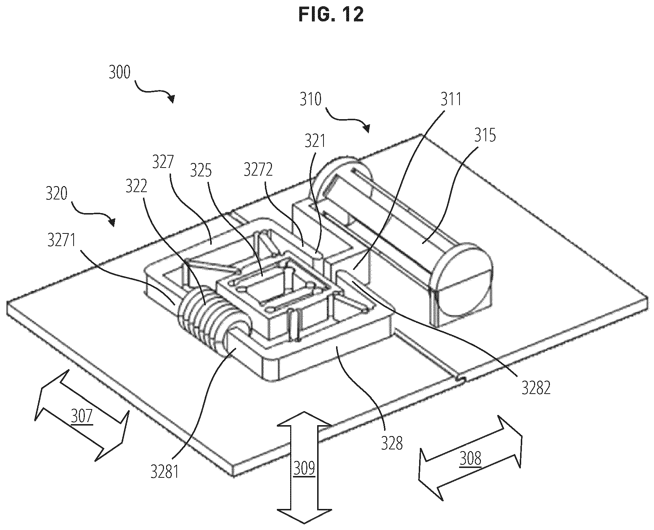

With reference to Figure 12, there is disclosed an electrical connection system 300. The electrical connection system 300 may comprise: a first body 310; a first electrical contact member 311 attached to the first body 310; a second body 320 movable relative to the first body 310; and a second electrical contact member 321 attached to the second body 320. As shown, the first and second bodies 310, 320 may be separated by a gap, so that they are not in rigid mechanical contact. During operation, the first and second bodies 310, 320 may move relative to each other due to mechanical vibrations. Such movements may typically be about 1 mm in amplitude in most directions, but may be as much as 4 mm in some applications. The electrical connection system 300 may further comprise a pneumatic actuator 322. The pneumatic actuator 322 may be a passive component. The pneumatic actuator 322 may be configured to change length in a first direction 307. The pneumatic actuator 322 may change length in response to changes in the fluid pressure surrounding the pneumatic actuator 322.

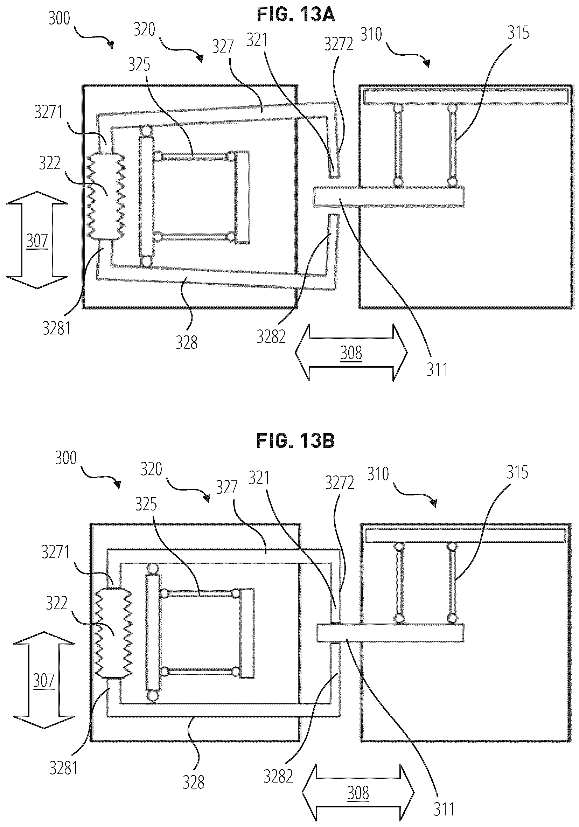

The electrical connection system 300 may have a disconnected state and a connected state. As shown in Figure 13A, in the disconnected state, the pneumatic actuator 322 may have a first length whereby the first and second electrical contact members 311, 321 are not in electrical contact. As shown in Figure 13B, in a connected state, the pneumatic actuator 322 may have a second length whereby the first and second electrical contact members 311, 321 are in electrical contact.

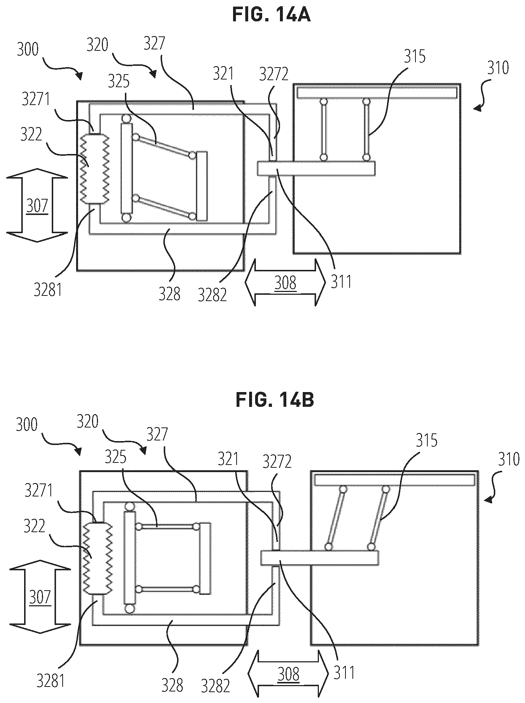

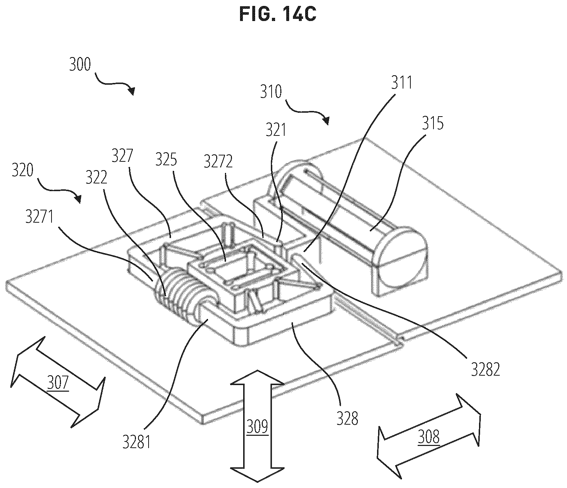

The electrical connection system 300 may further comprise a first compliant member 315 through which the first electrical contact member 311 is attached to the first body 310. The first compliant member 315 may configured to accommodate relative movements between the first and second bodies 310, 320 in one or more directions. For example, as shown in Figures 14B and 14C, the first compliant member 315 may accommodate relative movements between the first and second bodies 310, 320 in a second direction 308, 309 different from the first direction 307 (note that the relative movement in the direction 309 as shown in Figure 14C is visually small, but clearly observable by comparison with Figure 12). It should be understood that the first compliant member 315 may also accommodate relative movements in the first direction 307, i.e. the direction in which the pneumatic actuator 322 is configured to change length.

As a result, while the pneumatic actuator 322 changes length in response to changes in the surrounding pressure, the electrical connection system 300 may transition between the connected state and the disconnected state passively and automatically.

More specifically, the electrical connection system 300 may be configured to shift from the connected state to the disconnected state when the fluid pressure rises above a threshold. Additionally or alternatively, the electrical connection system 300 may be configured to shift from the disconnected state to the connected state when the fluid pressure falls below a threshold. It should be noted that the threshold for shifting from the connected state to the disconnected state may be the same or different from the threshold for shifting from the disconnected state to the connected state. That is, an amount of hysteresis may exist, which may be by design or due to material properties, friction, and the like.

When the electrical connection system 300 is configured for a vacuum enclosure, such as in the electron-optical apparatus 140, the threshold may be set at a value somewhere between atmospheric pressure and the vacuum pressure used during normal operation. In particular, as may be the case for the electron-optical apparatus 140, an electrical connection may always be required during normal operation, and a disconnection may always be required during maintenance. Therefore, by configuring the pressure threshold accordingly, the electrical connection system 300 may always be in the required state (i.e. disconnected or connected).

In particular, especially in high-voltage and/or vacuum applications, while in the connected state, the first and second electrical contact members 311, 321 can sometimes become welded together, for example due to large transient currents and arcing. As the pneumatic actuator 322 responds to the fluid pressure crossing the threshold, the pneumatic actuator 322 may be sized to generate enough force to break any welded spots, so as to shift the electrical connection system 300 from the connected state to the disconnected state.

As shown in Figures 13A and 13B, the pneumatic actuator 322 may be configured to increase in length in response to a decreasing fluid pressure. That is, as the fluid pressure decreases, the gas or gas mixture inside the pneumatic actuator 322 may expand and cause the increase in length. Conversely, the pneumatic actuator 322 may be configured to decrease in length in response to an increasing fluid pressure.

It should be noted that the opposite configuration is also possible, depending on the technical application. That is, the pneumatic actuator 322 may be configured to decrease in length in response to a decreasing fluid pressure, and/or the pneumatic actuator 322 may be configured to increase in length in response to an increasing fluid pressure. This configuration may be useful, for example, for when a disconnection is required when the apparatus is under vacuum and a connection is required when the apparatus is at atmospheric pressure. This configuration may also be useful for apparatuses that normally operate at a positive pressure, and which return to atmospheric pressure for maintenance.

As shown in Figures 12, 13A and 13B, the first direction 307 and the second direction 308, 309 may be orthogonal to each other. It should be understood, however, that the first direction 307 and the second direction 308, 309 need not necessarily be orthogonal to each other; they may generally be non-parallel to each other.

The first compliant member 315 may serve to accommodate relative movements in more than one direction. For example, the first compliant member 315 may be further configured to accommodate relative movements between the first and second bodies 310, 320 in a third direction 309 different from each of the first direction 307 and the second direction 308. The third direction 309 may be orthogonal to each of the first and second directions 307, 308. As before, it should be understood that the first, second and third directions 307, 308, 309, need not necessarily be orthogonal to one another; they may generally be mutually non-parallel to one another. More particularly, the first, second and third directions 307, 308, 309 may not be on the same plane.

The electrical connection system 300 may further comprise a second compliant member 325. As shown in Figure 14A, the second compliant member 325 may be configured to accommodate relative movements between the first and second bodies 310, 320 in the first direction 307.

As such, by providing the first compliant member 315 to accommodate relative movements in the second and third directions 308, 309, and the second compliant member 325 to accommodation relative movements in the first direction 307, where the first, second and third directions 307, 308, 309 are not in the same plane, the electrical connection system 300 may accommodate relative movements between the first body 310 and the second body 320 with three linear degrees of freedom, all the while maintaining the connected state when required, and automatically and passively shifting to the disconnected state in response to an appropriate pressure change.

The first and/or second compliant members 315, 325 may be variously implemented. For example, as shown in Figures 12 to 14C, they may be implemented using one or more leaf springs. Alternatively, they may be implemented using one or more helical or torsional springs. As yet another alternative, they may be implemented using a resilient material such as rubber or foam. A mixture or combination of the aforesaid may also be used.

It should be noted that the electrical connection system 300 may additionally accommodate relative rotational movements between the first body 310 and the second body 320 with one, two or three degrees of rotational freedom. Therefore, in sum, the electrical connection system 300 may accommodate relative movements with up to six degrees of freedom as required. The first and/or second compliant members 315, 325 may be configured especially to accommodate rotational relative movements. Alternatively, the inherent flexibility in the material from which the first and/or second compliant members 315, 325 are constructed may provide the requisite amount of accommodation of rotational relative movements.

While the first and/or second compliant members 315, 325, may be useful for accommodating relative movements between the first and second bodies 310, 320, it may be desirable to ensure that there are no unconstrained internal degrees of freedom. For example, an unconstrained degree of freedom may arise when both the first and second compliant members 315, 325 have significant compliance in a common direction. The existence of an unconstrained degree of freedom may allow certain parts to vibrate, or even resonate. Therefore, it may be desirable for relative movements in each of the first, second and third directions 307, 308, 309 to be accommodated substantially exclusively by one, and not both, of the first and second compliant members 315, 325.

The degrees of freedom may be variously distributed between the first and second compliant members 315, 325. For example, the second compliant member 325 may be more rigid than the first compliant member 315 in the second direction 308, 309. Therefore, relative movements in the second direction 308, 309 may be accommodated substantially exclusively by the second compliant member 325.

Alternatively or additionally, the second compliant member 325 may be more rigid than the first compliant member 315 in the third direction 309, the third direction 309 being different from (but not necessarily orthogonal to) each of the first direction 307 and the second direction 308. Therefore, relative movements in the third direction 309 may be accommodated substantially exclusively by the second compliant member 325.

Alternatively or additionally. the first compliant member 315 may be more rigid than the second compliant member 325 in the first direction 307. Therefore, relative movements in the first direction 307 may be accommodated substantially exclusively by the first compliant member 315.

The first and second compliant members 315, 325 may be provided anywhere within the electrical connection system 300 as long as they are capable of performing their respective functions. For example, as shown in Figures 12 to 14C, the second compliant member 325 may be attached to the second body 320. The first compliant member 315 may be attached to the first body 310.

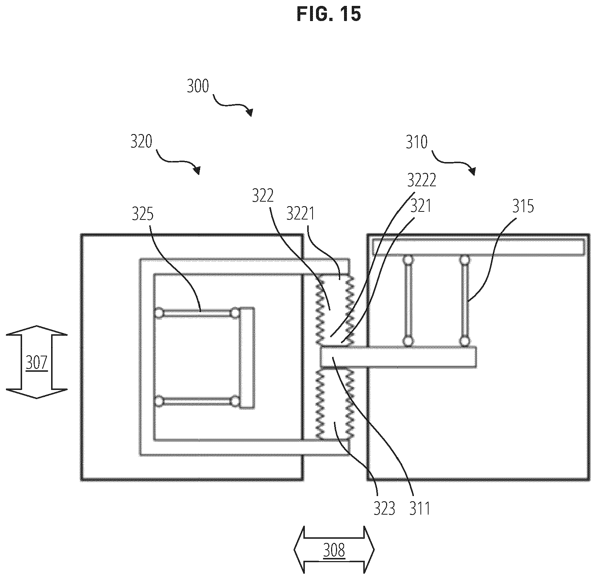

As shown in Figures 12 to 15, the second compliant member 325 may be provided to accommodate relative movements between the first and second bodies 310, 320 in the first direction 307. However, for simplicity, it is possible exploit the compliance of the pneumatic actuator 322, so that it additionally serves as the second compliant member 325. That is, in Figure 15, for example, the item shown as the second compliant member 325 may be replaced by a rigid attachment, and the pneumatic actuator 322, by virtue of its compliance, may perform the same function as the second compliant member 325 as shown.

The pneumatic actuator 322 may be variously implemented. For example, the pneumatic actuator 322 may comprise a sealed internal volume, wherein a change in the volume causes the pneumatic actuator 322 to change length. More particularly, the pneumatic actuator 322 may comprise a bellows, and the sealed internal volume is the internal volume of the bellows. The bellows may be constructed out of metal, for example stainless steel. Compared with other implementations, the use of a bellows may avoid creating a sliding electrical contact. Sliding contacts may be undesirable because they may cause abrasion and generate contaminant particles.

As used herein, the term "a bellows" refers to a single item.

Other implementations of the pneumatic actuator 322 are possible. For example, the pneumatic actuator 322 may comprise a balloon or a bulb, which may be made of an elastomer. The pneumatic actuator 322 may alternatively comprise a closed-cell foam. As yet another alternative, the pneumatic actuator 322 may comprise a piston.

The amount of gas present in the pneumatic actuator 322 can be varied as required, as long as the pneumatic actuator 322 is capable of changing length in response to fluid pressure changes relevant for the particular technical application. For example, when the pneumatic actuator 322 is in an unstressed state, the sealed internal volume may be filled with a gas or gas mixture at atmospheric pressure. As used herein, the term "unstressed state" refers to a state in which the mechanical forces in the pneumatic actuator 322 in isolation are in equilibrium, and the pressures inside and outside of the pneumatic actuator 322 are equal. While in the unstressed state, internal mechanical stresses may nevertheless exist in the construction material of the pneumatic actuator 322. It should also be noted that substantially no gas (i.e. substantially perfect vacuum) is present in the internal volume of the pneumatic actuator 322 (the pneumatic actuator 322 would still be able to change length given appropriate surrounding fluid pressures).

Various gasses or gas mixtures may fill the internal volume of the pneumatic actuator 322, such as air, nitrogen, or an insert gas, or a gas mixture free of oxygen and/or hydrogen.

The pneumatic actuator 322 may be provided anywhere within the electrical connection system 300 as long as it is capable of performing its intended function. For example, as shown in Figures 12 to 15, the pneumatic actuator 322 may be attached to the second body 320.

The pneumatic actuator 322, by changing length, may cause the transition between the connected state and the disconnected state through various means. For example, the pneumatic actuator 322 may act indirectly. For example, as shown in Figures 12 to 14C, the electrical connection system 300 may further comprise a lever 327, wherein the pneumatic actuator 322 is configured to act through a first end 3271 of the lever 327.

The second electrical contact member 321 may provided on a second end 3272 of the lever 327. For example, the second electrical contact member 321 may be integrally formed with the second end 3272 of the lever 327.

As shown, the lever 327 may be rotatably attached to the second body 320. For example, as shown, the lever 327 may be attached to the second body 320 through the second compliant member 325. The lever 327 may be integrally formed with the second compliant member 325, and may be able to rotate due to the compliance of the second compliant member 325. The lever 327 may be rotatable about a virtual pivot point.

As shown in Figures 12 to 14C, the electrical connection system 300 may further comprise a second lever 328. The pneumatic actuator 322 may be positioned between a first end 3281 of the second lever 328 and the first end 3271 of the first lever 327, whereby the pneumatic actuator 322 is configured to act through both the first and second levers 327, 328. The first electrical contact member 311 may be positionable between the second end 3272 of the first lever 327 and a second end 3282 of the second lever 328.

As shown, an increase in length of the pneumatic actuator 322 may result in a decrease in distance between the second end 3272 of the first lever 327 and the second end 3272 of the second lever 328. In other words, the first and second levers 327, 328 may form a clamp configured to clamp onto the first electrical contact member 311 in the connected state. The clamping force may be sufficient to maintain a reliable electrical connection. For example, in one implementation, the bellows may have a cross-sectional area of about 1 cm², and the contact force may be about 5 N to 9 N.

Conversely, as shown, a decrease in length of the pneumatic actuator 322 may result in an increase in distance between the second end 3272 of the first lever 327 and the second end 3272 of the second lever 328. This may provide a force sufficient to break any weld that may have formed between the first electrical contact member 311 and the second electrical contact member 321.

Furthermore, by providing two levers 327, 328, the forces acting on the first electrical contact member 311 may be symmetrical (that is, equal and opposite), so that the first electrical contact member 311 is not biased towards one side.

Furthermore, by providing two levers 327, 328 and positioning the pneumatic actuator 322 between the first end 3281 of the second lever 328 and the first end 3271 of the first lever 327, a single pneumatic actuator 322 may be required for implement the actuation.

One or both of the first and second levers 327, 328 may be electrically conductive. Therefore, one or both of the first and second levers 327, 328 may serve as part of the electrically conductive path. Alternatively, it should be understood that the first and second levers 327, 328 may be non-conductive, and a separate electrical conductor (e.g. a cable) may be provided to complete the conductive path from the second electrical contact member 321. It should also be noted that an additional electrical contact member (shown without reference sign) may be provided on the second end 3282 of the second lever 328.

As shown in Figure 15, instead of acting through levers, the pneumatic actuator 322 may have a stationary end 3221 which is rigidly attached to the second body 320. The pneumatic actuator 322 may have an actuation end which is movable relative to the stationary end 3221, thereby allowing the pneumatic actuator 322 to change length. In this configuration, the pneumatic actuator 322 may act directly. For example, the second electrical contact member 321 may be provided on, or integrally formed with, the actuation end 3222 of the pneumatic actuator 322.

The electrical connection system 300 may further comprise a second pneumatic actuator 323 attached to the second body 320. As shown in Figure 15, the first and second pneumatic actuators 322, 323 may be positioned to actuate in opposite directions. The first electrical contact member 311 may be positionable between the first and second pneumatic actuators 322, 323. As such, the first and second pneumatic actuators 322, 323 may exert substantially equal and opposite forces on the first electrical contact member 311 when in the connected state. This may prevent biasing the 311 towards one side.

One or both of the first and second pneumatic actuators 322, 323 may be electrically conductive. As a result, the one or both of the first and second pneumatic actuators 322, 323 may form part of the electrically conductive path. Alternatively, one or both of the first and second pneumatic actuators 322, 323 may be non-conductive, and a separate electrical conductor may be provided to complete the conductive path from the second electrical contact member 321.

The first and second bodies 310, 320 may be the voltage shielding plates mentioned above. The first and second bodies 310, 320 may be laterally overlapped so as to form a voltage shield. The voltage shield may be continuous. The first and second bodies 310, 320 may be separated by a gap so as to allow relative movement.

The charged particle-optical apparatus may comprise the electrical connection system 300.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

Aspects of the invention are described in the following numbered clauses.
Clause 1: An electrical connection system comprising: a first body; a first electrical contact member attached to the first body; a second body movable relative to the first body; a second electrical contact member attached to the second body; and a passive pneumatic actuator configured to change length in a first direction in response to changes in the fluid pressure surrounding the pneumatic actuator; wherein, in a disconnected state, the pneumatic actuator has a first length whereby the first and second electrical contact members are not in electrical contact; wherein, in a connected state, the pneumatic actuator has a second length whereby the first and second electrical contact members are in electrical contact; wherein the system further comprises a first compliant member through which the first electrical contact member is attached to the first body, and the first compliant member is configured to accommodate relative movements between the first and second bodies in a second direction different from the first direction.
Clause 2: The system of clause 1, configured to shift from the connected state to the disconnected state when the fluid pressure rises above a threshold.
Clause 3: The system of clause 1 or 2, configured to shift from the disconnected state to the connected state when the fluid pressure falls below a threshold.
Clause 4: The system of any one of the preceding clauses, wherein the pneumatic actuator is configured to increase in length in response to a decreasing fluid pressure.
Clause 5: The system of any one of the preceding clauses, wherein the pneumatic actuator is configured to decrease in length in response to an increasing fluid pressure.
Clause 6: The system of any one of the preceding clauses, wherein the first and second directions are orthogonal to each other.
Clause 7: The system of any one of the preceding clauses, wherein the first compliant member is further configured to accommodate relative movements between the first and second bodies in a third direction different from each of the first and second directions.
Clause 8: The system of clause 7, wherein the third direction is orthogonal to each of the first and second directions.
Clause 9: The system of any one of the preceding clauses, the system comprising a second compliant member configured to accommodate relative movements between the first and second bodies in the first direction.
Clause 10: The system of clause 9, wherein the second compliant member is more rigid than the first compliant member in the second direction.
Clause 11: The system of clause 9 or 10, wherein the second compliant member is more rigid than the first compliant member in the third direction, different from each of the first and second directions.
Clause 12: The system of any one of clauses 9 to 11, wherein the second compliant member is attached to the second body.
Clause 13: The system of any one of clauses 9 to 12, wherein the first compliant member is more rigid than the second compliant member in the first direction.
Clause 14: The system of any one of clauses 9 to 13, wherein the pneumatic actuator serves as the second compliant member.
Clause 15: The system of any one of the preceding clauses, wherein the pneumatic actuator comprises a sealed internal volume, wherein a change in the volume causes the pneumatic actuator to change length.
Clause 16: The system of clause 15, wherein the pneumatic actuator comprises a bellows, and the sealed internal volume is the internal volume of the bellows.
Clause 17: The system of clause 15 or 16, wherein, when the pneumatic actuator is in an unstressed state, the sealed internal volume is filled with a gas or gas mixture at atmospheric pressure.
Clause 18: The system of any one of the preceding clauses, wherein the pneumatic actuator is attached to the second body.
Clause 19: The system of any one of the preceding clauses, further comprising a lever, wherein the pneumatic actuator is configured to act through a first end of the lever.
Clause 20: The system of clause 19, wherein the second electrical contact member is provided on a second end of the lever.
Clause 21: The system of clause 19 or 20, wherein the lever is rotatably attached to the second body.
Clause 22: The system of any one of clauses 19 to 21, further comprising a second lever, wherein the pneumatic actuator is positioned between a first end of the second lever and the first end of the first lever, whereby the pneumatic actuator is configured to act through both the first and second levers.
Clause 23: The system of clause 22, wherein the first electrical contact member is positionable between the second end of the first lever and a second end of the second lever.
Clause 24: The system of clause 23, wherein an increase in length of the pneumatic actuator results in a decrease in distance between the second end of the first lever and the second end of the second lever
Clause 25: The system of clause 23 or 24, wherein a decrease in length of the pneumatic actuator results in an increase in distance between the second end of the first lever and the second end of the second lever
Clause 26: The system of any one of clauses 19 to 25, wherein one or both of the first and second levers is electrically conductive.
Clause 27: The system of clause 18, wherein a stationary end of the pneumatic actuator is rigidly attached to the second body.
Clause 28: The system of clause 27, wherein an actuation end of the pneumatic actuator is movable relative to the stationary end, thereby allowing the pneumatic actuator to change length.
Clause 29: The system of clause 28, wherein the second electrical contact member is provided on, or integrally formed with, the actuation end of the pneumatic actuator.
Clause 30: The system of any one of clauses 27 to 29, further comprising a second pneumatic actuator attached to the second body.
Clause 31: The system of clause 30, wherein the first and second pneumatic actuators are positioned to actuate in opposite directions.
Clause 32: The system of clause 31, wherein the first electrical contact member is positionable between the first and second pneumatic actuators.
Clause 33: The system of any one of clauses 27 to 32, wherein one or both of the first and second pneumatic actuators is electrically conductive.
Clause 34: The system of any one of the preceding clauses, wherein the first and second bodies are voltage shielding plates.
Clause 35: The system of clause 34, wherein the first and second bodies are laterally overlapped so as to form a voltage shield, and are separated by a gap so as to allow relative movement.
Clause 36: A charged particle-optical apparatus comprising the electrical connection system of any one of the preceding clauses.
Clause 37: An electrical connection system comprising: a first body; a first electrical contact member attached to the first body; a second body movable relative to the first body; a second electrical contact member attached to the second body; and a passive pneumatic actuator configured to change length in a first direction in response to changes in the fluid pressure surrounding the pneumatic actuator; wherein, in a disconnected state, the pneumatic actuator has a first length whereby the first and second electrical contact members are not in electrical contact; wherein, in a connected state, the pneumatic actuator has a second length whereby the first and second electrical contact members are in electrical contact; wherein the system further comprises a first compliant member through which the first electrical contact member is attached to the first body, and the first compliant member is configured to accommodate relative movements between the first and second bodies.

List of reference numerals:
100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
148 first multipole lens
150 controller
158 second multipole lens
201 source
202 source beam
204 electron-optical axis
207 sample holder
208 sample
209 actuatable stage
211, 212, 213 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
291 photon converter array
292 fluorescent strip
293 openings
295 deflector array
296 magnetic deflector
297 electrostatic deflector
298 optical fiber
299 electron-optical device array
300 electrical connection system
311 first electrical contact member
310 first body
320 second body
321 second electrical contact member
322 pneumatic actuator
307 first direction
308 another direction
309 another direction
315 first compliant member
325 second compliant member
327 first lever
3271 first end of the first lever
3272 second end of the first lever
328 second lever
3281 first end of the second lever
3282 second end of the second lever
3221 stationary end
3222 actuation end
323 second pneumatic actuator

## Claims

1. An electrical connection system comprising:
a first body;
a first electrical contact member attached to the first body;
a second body movable relative to the first body;
a second electrical contact member attached to the second body; and
a passive pneumatic actuator configured to change length in a first direction in response to changes in the fluid pressure surrounding the pneumatic actuator;
wherein, in a disconnected state, the pneumatic actuator has a first length whereby the first and second electrical contact members are not in electrical contact;
wherein, in a connected state, the pneumatic actuator has a second length whereby the first and second electrical contact members are in electrical contact;
wherein the system further comprises a first compliant member through which the first electrical contact member is attached to the first body, and the first compliant member is configured to accommodate relative movements between the first and second bodies in a second direction different from the first direction.

2. The system of claim 1, configured to shift from the connected state to the disconnected state when the fluid pressure rises above a threshold.

3. The system of claim 1, configured to shift from the disconnected state to the connected state when the fluid pressure falls below a threshold.

4. The system of claim 1, wherein the first compliant member is further configured to accommodate relative movements between the first and second bodies in a third direction different from each of the first and second directions.

5. The system of claim 1, the system comprising a second compliant member configured to accommodate relative movements between the first and second bodies in the first direction.

6. The system of claim 1, wherein the pneumatic actuator comprises a sealed internal volume, wherein a change in the volume causes the pneumatic actuator to change length.

7. The system of claim 1, further comprising a lever, wherein the pneumatic actuator is configured to act through a first end of the lever.

8. The system of claim 7, further comprising a second lever, wherein the pneumatic actuator is positioned between a first end of the second lever and the first end of the first lever, whereby the pneumatic actuator is configured to act through both the first and second levers.

9. The system of claim 8, wherein the first electrical contact member is positionable between the second end of the first lever and a second end of the second lever.

10. The system of claim 1, wherein a stationary end of the pneumatic actuator is rigidly attached to the second body.

11. The system of claim 10, further comprising a second pneumatic actuator attached to the second body.

12. The system of claim 11, wherein the first and second pneumatic actuators are positioned to actuate in opposite directions.

13. The system of claim 12, wherein the first electrical contact member is positionable between the first and second pneumatic actuators.

14. A charged particle-optical apparatus comprising the electrical connection system of claim 1.

15. An electrical connection system comprising:
a first body;
a first electrical contact member attached to the first body;
a second body movable relative to the first body;
a second electrical contact member attached to the second body; and
a passive pneumatic actuator configured to change length in a first direction in response to changes in the fluid pressure surrounding the pneumatic actuator;
wherein, in a disconnected state, the pneumatic actuator has a first length whereby the first and second electrical contact members are not in electrical contact;
wherein, in a connected state, the pneumatic actuator has a second length whereby the first and second electrical contact members are in electrical contact;
wherein the system further comprises a first compliant member through which the first electrical contact member is attached to the first body, and the first compliant member is configured to accommodate relative movements between the first and second bodies.
